# FASCICULE DE BREVET EUROPEEN

(11) **EP 0 645 773 B1**
(45) Date de publication et mention de la délivrance du brevet: **19.05.1999**
(21) Numéro de dépôt: 94402149.2
(22) Date de dépôt: 27.09.1994
(51) Int. Cl.: G06K 19/07, G11C 8/00, G11C 5/00, G11C 7/00

(54) **Procédé de mise à jour d'une mémoire et carte à mémoire mettant en oeuvre ce procédé**
Verfahren zum Aktualisieren eines Speicher und Speicherkarte zur Durchführung des Verfahrens
Procedure to update a memory card and memory card implementing this procedure

(30) Priorité: 29.09.1993 FR 9311570
(43) Date de publication de la demande: 29.03.1995
(73) Titulaire: FRANCE TELECOM, 75015 Paris (FR); LA POSTE, F-92777 Boulogne Billancourt Cédex (FR)
(72) Inventeur: Remery, Patrick, F-14000 Caen (FR); Menconi, Martial, F-14000 Caen (FR); Sabatier, Guy, F-75012 Paris (FR)
(74) Mandataire: Signore, Robert

(56) Documents cités:
- EP-A- 0 340 981
- EP-A- 0 536 792
- PATENT ABSTRACTS OF JAPAN vol. 5, no. 73 (P-061) 15 Mai 1981 & JP-A-56 019 593 (NTT) 24 Février 1981

## Description

### Domaine technique

La présente invention a pour objet un procédé de mise à jour d'une mémoire et une carte à mémoire mettant en oeuvre ce procédé. Elle trouve une application générale en informatique et plus particulièrement dans la technique du paiement électronique, notamment par porte-monnaie électronique.

### Etat de la technique antérieure

La demande de brevet français FR-A-2 665 791 ainsi que la demande de brevet européen EP-A-0 340 981 décrivent des procédés de mise à jour d'une mémoire. Dans ces procédés, la mémoire est divisée en m emplacements mémoire qui contiennent les m dernières mises à jour d'une information. Une nouvelle mise à jour est écrite dans l'emplacement mémoire où figurait la plus ancienne mise à jour.

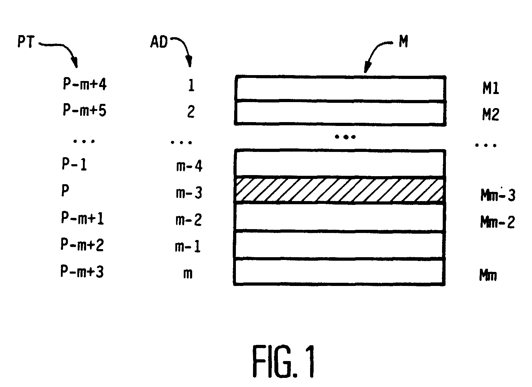

La figure 1 annexée rappelle l'essentiel de ce procédé. Les m emplacements de la mémoire sont référencés M1, M2, ..., Mm et sont repérés par des adresses AD qui vont de 1 à m. Un pointeur PT permet de retrouver les emplacements où ont été écrits les m dernières mises à jour. La valeur P de ce pointeur indique l'emplacement de la dernière mise à jour. Sur la figure 1 il s'agit de l'emplacement mémoire Mm-3 d'adresse m-3 (zone hachurée). La précédente mise à jour correspond au pointeur P-1, celle d'avant au pointeur P-2, etc... jusqu'à la plus ancienne mise à jour qui correspond au pointeur P-m+1.

Lorsqu'il s'agira d'écrire une nouvelle mise à jour, le pointeur P indiquera l'adresse (m-3) de l'emplacement mémoire (Mm-3) où figure la dernière mise à jour. On pourra alors calculer l'adresse suivante, soit (m-2), et l'on écrira dans l'emplacement correspondant (Mm-2) la nouvelle mise à jour. On fera passer le pointeur de la valeur P-m+1 à la valeur P pour indiquer le nouvel emplacement de la dernière mise à jour et l'on décalera tous les autres pointeurs d'une unité.

Ainsi, les nouvelles mises à jour seront-elles écrites de manière cyclique dans la mémoire, en remplacement progressif des plus anciennes. On parle alors de mise à jour cyclique, ou de mémoire cyclique.

Bien que satisfaisant à certains égards, ce procédé présente cependant un inconvénient. En effet, il conduit à effacer systématiquement d'anciennes mises à jour au profit des nouvelles, alors même que les nouvelles mises à jour pourraient ne pas présenter une importance plus grande que les anciennes. Par exemple, dans le cas du paiement électronique par porte-monnaie avec des publiphones, le porte-monnaie est débité au fil des unités téléphoniques consommées et il n'est pas avantageux de garder la trace de tous les débits. Il peut être souhaitable de ne garder que la trace du total des débits et de ne pas effacer les informations relatives à des communications antérieures, car celles-ci peuvent être utiles en cas de contestation de la part de l'usager de la carte.

En d'autres termes, dans le procédé antérieur, il n'y a pas de discrimination entre les diverses informations à mémoriser et à mettre à jour, ce qui n'est guère satisfaisant.

### Exposé de l'invention

La présente invention a justement pour but de remédier à cet inconvénient. A cette fin, l'invention préconise d'attribuer un certain degré d'importance aux diverses informations à mettre à jour. Pour une information de faible importance, on n'affectera qu'un faible nombre d'emplacements mémoire. Pour un autre type d'information, plus important, on affectera un nombre plus important d'emplacements mémoire à la mise à jour.

Dans un groupe affecté à la mise à jour, celle-ci s'effectuera de façon cyclique : on effacera la plus ancienne mise à jour et on y écrira, à la place, la nouvelle. On progressera ainsi d'emplacement en emplacement mais en restant dans le groupe attribué. On gardera donc la trace de certaines des mises à jour antérieures, mais seulement en nombre limité, ce nombre étant fonction du degré d'importance attaché à l'information.

En d'autres termes, on distingue les informations selon leur importance et l'on affecte à la mise à jour, une zone mémoire plus ou moins vaste selon l'importance de l'information à mettre à jour.

De façon précise, la présente invention a pour objet un procédé de mise à jour d'une mémoire, dans lequel la mémoire est divisée en plusieurs (m) emplacements mémoire aptes à contenir respectivement la dernière mise à jour relative à une information et différentes mises à jour antérieures, ce procédé étant caractérisé par le fait que :
- on attribue à chaque type d'information à mettre à jour un certain degré d'importance compris entre 2 et m,
- pour mettre à jour une information ayant un degré d'importance déterminé, on affecte à cette mise à jour un groupe d'emplacements mémoire dont le nombre est fonction de ce degré, ce groupe étant situé après le groupe d'emplacements contenant la dernière mise à jour, et l'on écrit cycliquement les différentes mises à jour dans ce groupe, ne gardant ainsi qu'un nombre limité de dernières mises à jour qui est fonction du degré d'importance affecté à l'information.

L'invention couvre tous les cas où le degré d'importance, (donc le nombre d'emplacements affectés à la mise à jour), va de 2 à m (un degré 0 signifierait qu'on ne met pas à jour l'information en question et un degré 1 qu'on réécrit les mises à jour dans un seul emplacement mémoire, ce qui est exclu ici).

Les informations traitées peuvent être de toute nature et concerner notamment des transactions, des débits, des crédits, des cumuls de débits, des cumuls de crédits, un solde, un nombre d'unités téléphoniques, etc...

La présente invention a également pour objet une carte à mémoire comprenant au moins une mémoire divisée en plusieurs emplacements mémoire, cette mémoire étant commandée par des moyens de mise à jour de son contenu, ces moyens étant aptes à recevoir une information et à commander l'écriture de la valeur à jour de cette information dans un emplacement mémoire approprié, cette carte se caractérisant par le fait qu'elle comprend en outre des moyens aptes à reconnaître le degré d'importance de l'information reçue et à limiter l'écriture des différentes mises à jour de cette information dans un groupe d'emplacements mémoire dont le nombre est fonction dudit degré d'importance.

### Brève description des dessins

- la figure 1, déjà décrite, illustre un procédé connu de mise à jour d'une mémoire ;
- la figure 2 est un organigramme illustrant un procédé selon l'invention ;
- la figure 3 illustre un exemple de mise à jour dans le cas d'une information d'importance 2.

### Exposé détaillé de modes de réalisation

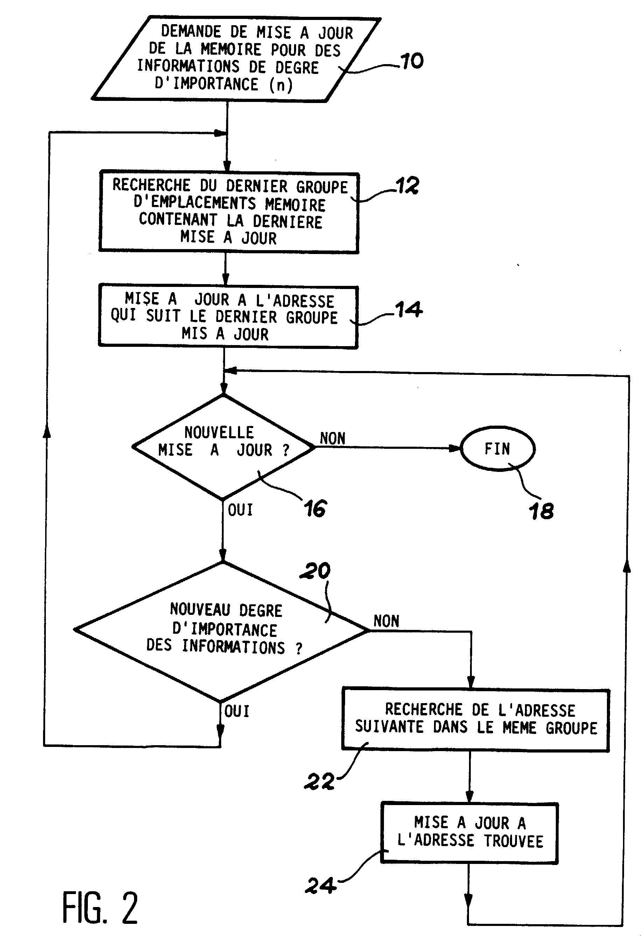

La figure 2 montre un organigramme illustrant le procédé de l'invention dans le cas simple où il n'existe que deux degrés d'importance. La question qui se pose est alors celle de savoir si l'information à mettre à jour présente le plus bas degré d'importance ou non. En d'autres termes, il va s'agir de savoir si l'information présente une certaine importance ou non.

Le procédé commence par une opération 10 de demande de mise à jour. Puis, par une opération 12, on recherche ce dernier groupe d'emplacements mémoire où a eu lieu la dernière mise à jour (recherche du pointeur P). On met alors à jour la mémoire en écrivant dans l'emplacement mémoire qui suit le dernier groupe d'emplacements mémoire trouvé, la nouvelle mise à jour (opération 14). S'il n'y a plus de nouvelle mise à jour à écrire (question 16), alors la mise à jour est achevée (18). Si la mise à jour doit se poursuivre, la question se pose (20) de savoir si l'information à enregistrer a le même degré d'importance. Si la réponse est affirmative, la mise à jour se poursuit par retour à l'opération 12. La séquence des mises à jour est écrite cycliquement. Si la réponse est négative, on recherche (opération 22) l'adresse de l'emplacement où a été écrite la dernière mise à jour dans le même groupe d'emplacements mémoire et l'on écrit la nouvelle mise à jour à l'emplacement qui suit (opération 24). Cela signifie que l'avant dernière mise à jour est "écrasée" par la nouvelle.

Dans cette hypothèse, compte tenu du peu d'importance de l'information à traiter, la plage accordée à la mise à jour est limitée à deux, alors que dans l'art antérieur, le processus de mise à jour se serait enclenché automatiquement et se serait développé à travers toute la mémoire. On peut dire, pour employer une terminologie empruntée à la mécanique, que le processus de mise à jour à été "débrayé", en raison du peu d'importance de l'information.

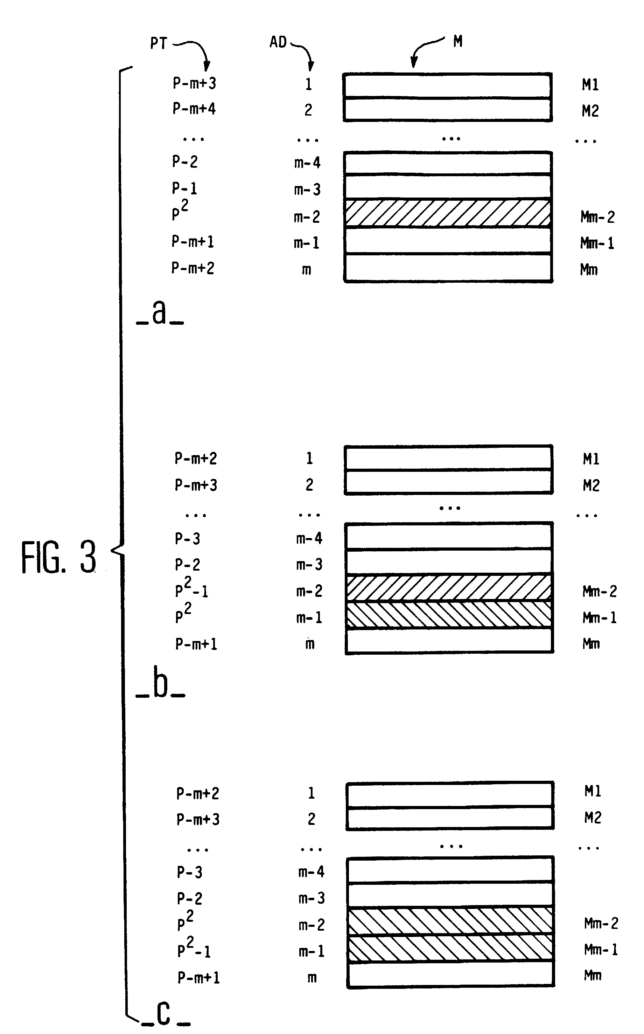

L'invention ne se limite naturellement pas au cas simple visé par l'organigramme de la figure 2, mais englobe tous les cas où plusieurs degrés d'importance peuvent être rencontrés. La figure 3 illustre un exemple où l'on rencontre une information de degré d'importance 2. Sur cette figure, et comme sur la figure 1, la référence littérale M indique la mémoire, laquelle est constituée de m emplacements mémoire M1, M2, ..., Mm ; la référence AD indique les adresses des emplacements mémoire, soit 1, 2, ..., m ; la référence PT se réfère au pointeur (P, P-1,P-2, ..., P-m+1).

Sur la figure 3, on suppose que l'information à mettre à jour possède le degré d'importance 2. La dernière mise à jour a été écrite dans l'emplacement Mm-2 (hachuré) d'adresse m-2. Le pointeur indiquant cette mise à jour est noté P² (l'exposant 2 indiquant qu'il s'agit d'un degré d'importance ²). C'est ce qui est représenté sur la partie (a) de la figure 3.

L'information ayant le degré d'importance 2, un groupe de deux emplacements mémoire est affecté à la mise à jour, respectivement Mm-2 et Mm-1. A l'arrivée de la nouvelle mise à jour, celle-ci sera donc écrite dans l'emplacement Mm-1 d'adresse m-1 et le pointeur sera modifié pour que P² indique l'emplacement Mm-1. L'emplacement Mm-2 garde la mise à jour précédente et le pointeur correspondant recule d'une unité et passe à P²-1. C'est ce qui est représenté sur la partie (b) de la figure 3.

Une nouvelle mise à jour (la troisième) sera effectuée en écrivant à nouveau dans l'emplacement Mm-2 la nouvelle valeur (ce qui implique qu'on "écrase" et donc qu'on perde la toute première mise à jour). On fait passer le pointeur correspondant à la valeur P². Le pointeur correspondant à l'emplacement Mm-1 passe à P²-1. C'est ce qui est représenté sur la partie c de la figure 3.

Si d'autres mises à jour de cette même information de degré d'importance 2 sont à effectuer, la séquence des diverses mises à jour sera écrite selon le même processus, toujours en n'occupant que les emplacements mémoire Mm-1 et Mm-2.

## Revendications

1. Procédé de mise à jour d'une mémoire, dans lequel la mémoire (M) est divisée en plusieurs (m) emplacements mémoire (M1, ..., Mm) aptes à contenir respectivement la dernière mise à jour relative à une information et différentes mises à jour antérieures, ce procédé étant caractérisé par le fait que :
- on attribue à chaque type d'information à mettre à jour un certain degré d'importance compris entre 2 et m, avec m > 2,
- pour mettre à jour une information ayant un degré d'importance déterminé, on affecte à cette mise à jour un groupe d'emplacements mémoire dont le nombre est fonction de ce degré, ce groupe étant situé après le groupe d'emplacements contenant la dernière mise à jour, et l'on écrit cycliquement les différentes mises à jour dans ce groupe, ne gardant ainsi qu'un nombre limité de dernières mises à jour, fonction du degré d'importance de l'information.

2. Procédé selon la revendication 1, caractérisé par le fait que, pour la mise à jour d'une information de degré d'importance 2, on affecte à cette mise à jour un groupe de deux emplacements mémoire et on écrit cycliquement la séquence des différentes mises à jour de cette information dans ce groupe de 2 emplacements mémoire, ne gardant ainsi que les deux dernières mises à jour de l'information.

3. Procédé selon la revendication 1, caractérisé par le fait que, pour la mise à jour d'une information ayant un degré d'importance le plus élevé (m), on affecte à cette mise à jour un groupe d'emplacements comprenant tous les emplacements (m) de la mémoire et on écrit cycliquement la séquence des différentes mises à jour dans la mémoire, gardant ainsi les m dernières mises à jour de l'information.

4. Procédé selon l'une quelconque des revendications 1 à 3, caractérisé par le fait que les informations à mettre à jour sont des informations liées à une transaction.

5. Procédé selon la revendication 4, caractérisé par le fait que l'information à mettre à jour est un débit, ou un cumul de débits, ou un crédit, ou un cumul de crédits.

6. Procédé selon la revendication 4, caractérisé par le fait que l'information à mettre à jour est un solde.

7. Procédé selon l'une quelconque des revendications 1 à 6, caractérisé par le fait qu'il est appliqué aux cartes à mémoire du type porte-monnaie électronique.

8. Carte à mémoire mettant en oeuvre le procédé selon l'une quelconque des revendications 1 à 7, cette carte comprenant au moins une mémoire divisée en plusieurs (m) emplacements mémoire (M1, ..., Mm), cette mémoire étant commandée par des moyens de mise à jour de son contenu, ces moyens étant aptes à recevoir une information et à commander l'écriture de la valeur à jour de l'information dans un emplacement mémoire approprié, cette carte étant caractérisée par le fait qu'elle comprend en outre des moyens aptes à reconnaître le degré d'importance de l'information reçue et à limiter l'écriture des différentes mises à jour de cette information dans un groupe d'emplacements mémoire dont le nombre est fonction dudit degré d'importance.

## Patentansprüche

1. Verfahren zum Aktualisieren eines Speichers, bei dem der Speicher (M) in mehrere (m) Speicherplätze (M1, ..., Mm) unterteilt ist, die die jeweils letzte, eine Information betreffende Aktualisierung und verschiedene frühere Aktualisierungen enthalten können,
**dadurch gekennzeichnet:**
- daß man jedem zu aktualisierenden Informationstyp einen bestimmten Wichtigkeitsgrad zuordnet, enthalten zwischen 2 und m, mit m > 2,
- daß man, um eine Information mit einem bestimmten Wichtigkeitsgrad zu aktualisieren, dieser Aktualisierung eine Gruppe Speicherplätze zuteilt, deren Anzahl abhängig ist von diesem Grad, wobei diese Gruppe sich hinter der Speicherplätzegruppe befindet, die die letzte Aktualisierung enthält, und man zyklisch die verschiedenen Aktualisierungen in diese Gruppe schreibt und so nur eine begrenzte Anzahl letzter Aktualisierungen behält, abhängig von der Wichtigkeit der Information.

2. Verfahren nach Anspruch 1, dadurch gekennzeichnet, daß man für die Aktualisierung einer Information des Wichtigkeitsgrads 2 dieser Aktualisierung eine Gruppe von zwei Speicherplätzen zuteilt und man zyklisch die Sequenz der verschiedenen Aktualisierungen dieser Information in diese Gruppe von 2 Speicherplätzen schreibt und so nur die beiden letzten Aktualisierungen der Information behält.

3. Verfahren nach Anspruch 1, dadurch gekennzeichnet, daß man für die Aktualisierung einer Information mit dem höchsten Wichtigkeitsgrad (m) dieser Aktualisierung eine Gruppe von Speicherplätzen zuteilt, die alle Speicherplätze (m) des Speichers umfaßt und man zyklisch die Sequenz der verschiedenen Aktualisierungen in den Speicher schreibt und so die m letzten Aktualisierungen der Information behält.

4. Verfahren nach einem der Ansprüche 1 bis 3, dadurch gekennzeichnet, daß die zu aktualisierenden Informationen mit einer Transaktion verbundene Informationen sind.

5. Verfahren nach Anspruch 4, dadurch gekennzeichnet, daß die zu aktualisierende Information ein Debet bzw. eine Lastschrift ist oder eine Summierung von Lastschriften, oder ein Kredit oder eine Summierung von Krediten.

6. Verfahren nach Anspruch 4, dadurch gekennzeichnet, daß die zu aktualisierende Information ein Saldo ist.

7. Verfahren nach einem der Ansprüche 1 bis 6, dadurch gekennzeichnet, daß es auf die Speicherkarten des Typs elektronisches Portemonnaie angewendet wird.

8. Speicherkarte zum Anwenden des Verfahrens nach einem der Ansprüche 1 bis 7, wobei diese Karte wenigstens einen in mehrere (m) Speicherplätze (M1, ..., Mm) aufgeteilten Speicher umfaßt und durch Aktualisierungseinrichtungen ihres Inhalts gesteuert wird und diese Einrichtungen dabei fähig sind, eine Information zu empfangen und das Einschreiben des laufenden Werts der Information in einen entsprechenden Speicherplatz zu steuern,
**dadurch gekennzeichnet,**
daß sie außerdem Einrichtungen umfaßt, die fähig sind, den Wichtigkeitsgrad der empfangenen Information zu erkennen und das Einschreiben der verschiedenen Aktualisierungen dieser Information auf eine Speicherplätzegruppe zu begrenzen, deren Anzahl abhängig ist von dem genannten Wichtigkeitsgrad.

## Claims

1. Method of updating a memory, in which the memory (M) is divided into a plurality (m) of memory locations (M1, ..., Mm) which can respectively contain the last update relating to an item of information and various previous updates, this method being characterized in that:
- each type of information to be updated is assigned a certain degree of importance lying between 2 and m, with m > 2,
- in order to update an item of information having a given degree of importance, this update is allocated a group of memory locations the number of which depends on this degree, this group being positioned after the group of locations containing the last update, and the various updates are written cyclically to this group, thus keeping only a limited number of last updates which depends on the degree of importance of the information.

2. Method according to Claim 1, characterized in that, in order to update an item of information with degree of importance 2, this update is allocated a group of two memory locations and the sequence of the various updates of this information is written cyclically to this group of 2 memory locations, thus keeping only the last two updates of the information.

3. Method according to Claim 1, characterized in that, in order to update an item of information having the highest degree of importance (m), this update is allocated a group of locations comprising all the locations (m) of the memory, and the sequence of the various updates is written cyclically to the memory, thus keeping the m last updates of the information.

4. Method according to any one of Claims 1 to 3, characterized in that the items of information to be updated are information connected with a transaction.

5. Method according to Claim 4, characterized in that the information to be updated is a debit, or an accumulation of debits, or a credit, or an accumulation of credits.

6. Method according to Claim 4, characterized in that the information to be updated is a balance.

7. Method according to any one of Claims 1 to 6, characterized in that it is applied to memory cards of the electronic purse type.

8. Memory card employing the method according to any one of Claims 1 to 7, this card comprising at least one memory divided into a plurality (m) of memory locations (M1, ..., Mm), this memory being controlled by means for updating its contents, these means being capable of receiving an information item and of having the current value of the information written to a suitable memory location, this card being characterized in that it furthermore comprises means capable of recognizing the degree of importance of the information received and of limiting the writing of the various updates of this information to a group of memory locations the number of which depends on the said degree of importance.
